# EUROPEAN PATENT APPLICATION

(11) **EP 4 669 079 A1**
(43) Date of publication of application: **24.12.2025**
(21) Application number: 25181479.4
(22) Date of filing: 06.06.2025
(51) Int. Cl.: H10K 59/32, H10K 50/826, H10K 59/80

(54) **LIGHT-EMITTING ELEMENT, DISPLAY DEVICE, AND ELECTRONIC DEVICE INCLUDING THE DISPLAY DEVICE**

(30) Priority: 17.06.2024 KR 20240078178; 21.08.2024 KR 20240112092
(71) Applicant: Samsung Display Co., Ltd., Yongin-si, Gyeonggi-do 17113 (KR)
(72) Inventor: CHOI, Hye Won, 17113 Yongin-si (KR); KIM, Dong Chan, 17113 Yongin-si (KR); LEE, Byung Seok, 17113 Yongin-si (KR)
(74) Representative: Marks & Clerk LLP

(57) **Abstract**

A light-emitting element is provided and includes an anode, a cathode opposite to the anode, a first light-emitting unit arranged on the anode, a first charge generation layer arranged on the first light-emitting unit, and a second light-emitting unit arranged between the first charge generation layer and the cathode. The cathode includes a first layer including a compound including silver and lithium, and a second layer arranged on the first layer and including a transparent oxide.

## Description

### CROSS-REFERENCE TO RELATED APPLICATION

### BACKGROUND

### 1. Field

One or more aspects of embodiments of the present disclosure relate to a light-emitting element, a display device, and an electronic device including the display device.

### 2. Description of the Related Art

With the development of information technologies, the importance of a display device, which is a connection medium between a user and information, has increased. Accordingly, one or more suitable display devices, such as a liquid crystal display device and an organic light-emitting display device, are increasingly being used.

The above information disclosed in this Background section is for enhancement of understanding of the background of the present disclosure, and therefore, it may contain information that does not constitute prior art.

### SUMMARY

One or more aspects of embodiments of the present disclosure are directed toward a light-emitting element and a display device having improved light emission efficiency.

One or more aspects of embodiments of the present disclosure are directed toward an electronic device including the light-emitting element and/or display device having improved light emission efficiency.

However, it should be noted that these objectives are merely examples, and the scope of the disclosure is not limited to the herein-mentioned aspects. Rather, other objectives of embodiments of the present disclosure will be apparent to those skilled in the art from the following descriptions.

According to one or more embodiments of the present disclosure, a light-emitting element includes: an anode, a cathode opposite to (e.g., facing) the anode, a first light-emitting unit arranged on the anode, a first charge generation layer arranged on the first light-emitting unit, and a second light-emitting unit arranged between the first charge generation layer and the cathode. The cathode includes a first layer including a compound including silver and a lithium portion, and a second layer arranged on the first layer and including a transparent oxide.

In some embodiments, the lithium portion may be a doping material.

In some embodiments, an amount (e.g., a content) of the lithium portion may be about 5 wt% to about 50 wt% based on a total weight of the compound.

In some embodiments, a thickness of the first layer may be in a range of about 5 nm (nanometers) to about 20 nm.

In some embodiments, a thickness of the second layer may be in a range of about 20 nm to about 100 nm.

In some embodiments, the first light-emitting unit may include a first hole transport layer, a first light-emitting layer arranged on the first hole transport layer, and a first electron transport layer arranged on the first light-emitting layer, and the second light-emitting unit may include a second hole transport layer, a second light-emitting layer arranged on the second hole transport layer and emitting light of the same color as the first light-emitting layer, (e.g., the first light-emitting layer and the second light-emitting layer each configured to emit light of a same color), and a second electron transport layer arranged on the second light-emitting layer.

In some embodiments, the first light-emitting unit may include a first hole transport layer, a blue light-emitting layer arranged on (e.g. on) the first hole transport layer, and a first electron transport layer arranged on (e.g. on) the blue light-emitting layer, and the second light-emitting unit may include a second hole transport layer, a red light-emitting layer arranged on (e.g. on) the second hole transport layer, a green light-emitting layer arranged on (e.g. on) the red light-emitting layer, and a second electron transport layer arranged on (e.g. on) the green light-emitting layer.

In some embodiments, the light-emitting element may further include a second charge generation layer arranged on the second light-emitting unit, and a third light-emitting unit arranged between (e.g. between) the second charge generation layer and the cathode.

In some embodiments, the first light-emitting unit may include a first hole transport layer, a red light-emitting layer arranged on (e.g. on) the first hole transport layer, and a first electron transport layer arranged on (e.g. on) the red light-emitting layer, the second light-emitting unit may include a second hole transport layer, a blue light-emitting layer arranged on (e.g. on) the second hole transport layer, and a second electron transport layer arranged on (e.g. on) the blue light-emitting layer, and the third light-emitting unit may include a third hole transport layer, a green light-emitting layer arranged on (e.g. on) the third hole transport layer, and a third electron transport layer arranged on (e.g. on) the green light-emitting layer.

In some embodiments, the light-emitting element may further include a capping layer arranged on (e.g. on) the cathode.

According to one or more embodiments of the present disclosure, a display device includes: a pixel circuit layer arranged on (e.g. on) a substrate, and a light-emitting element layer arranged on (e.g. on) the pixel circuit layer, the light-emitting element layer includes an anode, a cathode opposite to (e.g., facing) the anode, a first light-emitting unit arranged on (e.g. on) the anode, a first charge generation layer arranged on (e.g. on) the first light-emitting unit, and a second light-emitting unit arranged between (e.g. between) the first charge generation layer and the cathode. The cathode includes a first layer including a compound including silver and a lithium portion, and a second layer arranged on (e.g. on) the first layer and including a transparent oxide.

In some embodiments, the lithium portion may be a doping material.

In some embodiments, an amount (e.g., a content) of the lithium portion may be about 5 wt% to about 50 wt% based on a total weight of the compound.

In some embodiments, a thickness of the first layer may be in a range of about 5 nm to about 20 nm.

In some embodiments, a thickness of the second layer may be in a range of about 20 nm to about 100 nm.

In some embodiments, the first light-emitting unit may include a first hole transport layer, a first light-emitting layer arranged on (e.g. on) the first hole transport layer, and a first electron transport layer arranged on (e.g. on) the first light-emitting layer, and the second light-emitting unit may include a second hole transport layer, a second light-emitting layer arranged on (e.g. on) the second hole transport layer and emitting light of the same color as the first light-emitting layer, (e.g., the first light-emitting layer and the second light-emitting layer may each be configured to emit light of a same color), and a second electron transport layer arranged on (e.g. on) the second light-emitting layer.

In some embodiments, the first light-emitting unit may include a first hole transport layer, a blue light-emitting layer arranged on (e.g. on) the first hole transport layer, and a first electron transport layer arranged on (e.g. on) the blue light-emitting layer, and the second light-emitting unit may include a second hole transport layer, a red light-emitting layer arranged on (e.g. on) the second hole transport layer, a green light-emitting layer arranged on (e.g. on) the red light-emitting layer, and a second electron transport layer arranged on (e.g. on) the green light-emitting layer.

In some embodiments, the display device may further include a second charge generation layer arranged on (e.g. on) the second light-emitting unit, and a third light-emitting unit arranged between (e.g. between) the second charge generation layer and the cathode.

In some embodiments, the first light-emitting unit may include a first hole transport layer, a red light-emitting layer arranged on (e.g. on) the first hole transport layer, and a first electron transport layer arranged on (e.g. on) the red light-emitting layer, the second light-emitting unit may include a second hole transport layer, a blue light-emitting layer arranged on (e.g. on) the second hole transport layer, and a second electron transport layer arranged on (e.g. on) the blue light-emitting layer, and the third light-emitting unit may include a third hole transport layer, a green light-emitting layer arranged on (e.g. on) the third hole transport layer, and a third electron transport layer arranged on (e.g. on) the green light-emitting layer.

In some embodiments, the display device may further include a capping layer arranged on (e.g. on) the cathode.

In some embodiments, an electronic device includes the display device as described herein.

According to one or more embodiments of the present disclosure, an electronic device includes a display device that includes: a pixel circuit layer on a substrate, and a light-emitting element layer on the pixel circuit layer, the light-emitting element layer includes an anode, a cathode opposite to the anode, a first light-emitting unit arranged on the anode, a first charge generation layer on the first light-emitting unit, and a second light-emitting unit arranged between the first charge generation layer and the cathode. The cathode includes a first layer including a compound including silver and a lithium portion, and a second layer on the first layer and including a transparent oxide.

In one or more embodiments, the electronic device may be a smartphone, a television, a monitor, a tablet, an electric vehicle, a mobile phone, a tablet personal computer (PC), a mobile communication terminal, an electronic notebook, an electronic book, a portable multimedia player (PMP), a navigation device, an ultra-mobile PC (UMPC), a laptop computer, a billboard, an Internet of Things (IoT) device, a smartwatch, a watch phone, or a head-mounted display (HMD).

At least some of the above and other features of the invention are set out in the claims.

However, the present disclosure is not limited to the preceding aspects and features, and the preceding and additional aspects and features of embodiments will be set forth, in part, in the detailed description that follows with reference to the drawings, and in part, may be apparent therefrom, or may be learned by practicing one or more of the presented embodiments of the present disclosure.

### BRIEF DESCRIPTION OF THE DRAWINGS

The accompanying drawings are included to provide a further understanding of the preceding and other aspects and features of embodiments of the present disclosure and are incorporated in and constitute a part of this specification. The drawings illustrate example embodiments that will be more clearly understood from the following detailed description of the illustrative, non-limiting embodiments with reference to the accompanying drawings. In the drawings:
FIG. 1 is a plan view of a display device according to one or more one or more embodiments;
FIG. 2 is a cross-sectional view taken along line I-I' of FIG. 1 according to one or more one or more embodiments;
FIG. 3 is a cross-sectional view of a light-emitting element according to one or more one or more embodiments;
FIG. 4 is a cross-sectional view taken along line I-I' of FIG. 1 according to one or more one or more embodiments;
FIG. 5 is a cross-sectional view of a light-emitting element according to one or more one or more embodiments;
FIG. 6 is a cross-sectional view taken along line I-I' of FIG. 1 according to one or more one or more embodiments;
FIG. 7 is a cross-sectional view of a light-emitting element according to one or more one or more embodiments;
FIG. 8 is a cross-sectional view of a cathode according to one or more one or more embodiments;
FIG. 9 is a block diagram of a display system according to one or more one or more embodiments;
FIG. 10 is a perspective view illustrating an application example of the display system of FIG. 9 according to one or more one or more embodiments; and
FIG. 11 is a cross-sectional view illustrating a head mounted display device of FIG. 10 worn by a user according to one or more one or more embodiments.

### DETAILED DESCRIPTION

Hereinafter, one or more embodiments according to the disclosure are described in more detail with reference to the accompanying drawings. It should be noted that in the following description, only portions useful for understanding an operation according to the disclosure are described, and descriptions of other portions are not included in order not to obscure the subject matter of the disclosure. In some embodiments, the subject matter of the disclosure may be embodied in other forms without being limited to the one or more embodiments described herein. However, the one or more embodiments described herein are provided to describe in enough detail to easily implement the disclosure to those skilled in the art to which the disclosure belongs.

Throughout the specification, in a case where a portion is "connected" or "coupled" to another portion, the case includes not only a case where the portion is "directly connected" or "coupled" but also a case where the portion is "indirectly connected" or "coupled" with another element interposed therebetween. Terms used herein are for describing specific embodiments and are not intended to limit the disclosure. Throughout the specification, in a case where a certain portion "includes", "include," "including," "comprises," "comprise," "comprising," "having," "have," and "has" will be understood to encompass the case that the portion may further include another component without excluding another component unless otherwise stated. Throughout the disclosure, the expressions "at least one of X, Y, and Z," "at least any of X, Y, and Z," and "at least any selected from a group consisting of X, Y, and Z" may be interpreted as one X, one Y, one Z, or any combination of two or more of X, Y, and Z (for example, XYZ, XY, YZ, and ZZ). Here, "and/or" includes all combinations of one or more of corresponding configurations. As used herein, the singular forms "a," "an" and "the" are intended to include plural forms as well, unless the context clearly indicates otherwise.

Here, terms such as "first," "second" and/or the like may be used to describe one or more suitable components, but these components are not limited to these terms. These terms are used to distinguish one component from another component. Therefore, a first component may refer to a second component within a range without departing from the scope disclosed herein.

The term "may" will be understood to refer to "one or more embodiments of the present disclosure," some of which include the described element and some of which exclude that element and/or include an alternate element. Similarly, alternative language such as "or" refers to "one or more embodiments of the present disclosure," each including a corresponding listed item.

Spatially relative terms such as "below", "lower", "above", "on top", "on the top", "under", "on", and/or the like may be used for descriptive purposes, thereby describing a relationship between one element or feature and another element(s) or feature(s) as shown in the drawings. Spatially relative terms are intended to include other directions in use, in operation, and/or in manufacturing, in addition to the direction depicted in the drawings. For example, when a device shown in the drawing is turned upside down, elements depicted as being positioned "under" other elements or features are positioned in a direction "on" the other elements or features. Therefore, in one or more embodiments, the term "under" may include both directions of on and under. In some embodiments, the device may face in other directions (for example, rotated 90 degrees or in other directions) and thus the spatially relative terms used herein are interpreted according thereto.

One or more suitable embodiments are described with reference to drawings schematically illustrating ideal embodiments. Accordingly, it will be expected that shapes may vary, for example, according to tolerances and/or manufacturing techniques. Therefore, the embodiments disclosed herein cannot be construed as being limited to the specific shapes shown, and should be interpreted as including, for example, changes in shapes that occur as a result of manufacturing. As described herein, the shapes shown in the drawings may not show actual shapes of areas of a device, and the present embodiments are not limited thereto.

Unless otherwise defined, all terms (including chemical, technical and scientific terms) used herein have a same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

When a certain embodiment may be implemented differently, a specific process order may be performed differently from the described order. For example, two consecutively described processes may be performed substantially at the same time or performed in an order opposite to the described order.

In this context, "consisting essentially of" indicates that any additional components will not materially affect the chemical, physical, optical or electrical properties of the semiconductor film.

Further, in this specification, the phrase "plan view," indicates viewing a target portion from the top, and the phrase "on a cross-section" indicates viewing a cross-section formed by vertically cutting a target portion from the side.

Hereinafter, one or more embodiments of the disclosure are described in more detail with reference to the attached drawings.

### Display device

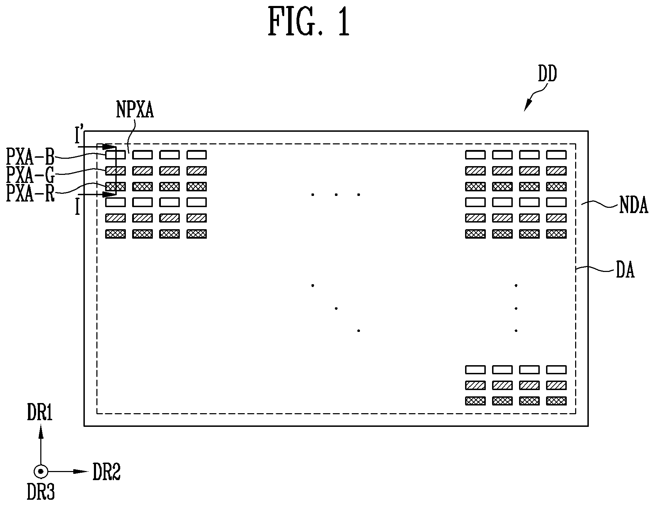

FIG. 1 is a plan view of a display device according to one or more embodiments.

Referring to FIG. 1, the display device DD may include a display area DA and a non-display area NDA. The display device DD may display images through the display area DA. The non-display area NDA may be arranged around the display area DA.

The display area DA may include red emission areas PXA-R, green emission areas PXA-G, blue emission areas PXA-B, and a non-emission area NPXA. The red emission areas PXA-R, the green emission areas PXA-G, and the blue emission areas PXA-B may be spaced and/or apart (e.g., spaced apart or separated) from each other. The non-emission area NPXA may be arranged around the red emission areas PXA-R, the green emission areas PXA-G, and the blue emission areas PXA-B.

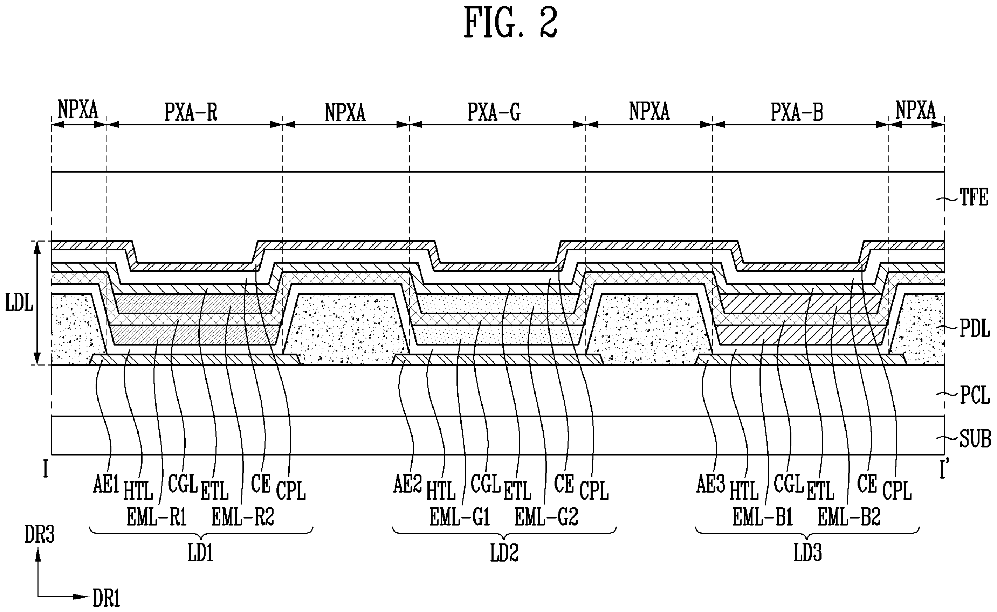

In one or more embodiments, the red emission area PXA-R may be an area where red light generated from a first light-emitting element LD1 (refer to FIG. 2) is emitted. The green emission area PXA-G may be an area where green light generated from a second light-emitting element LD2 (refer to FIG. 2) is emitted. The blue emission area PXA-B may be an area where blue light generated from a third light-emitting element LD3 (refer to FIG. 2) is emitted.

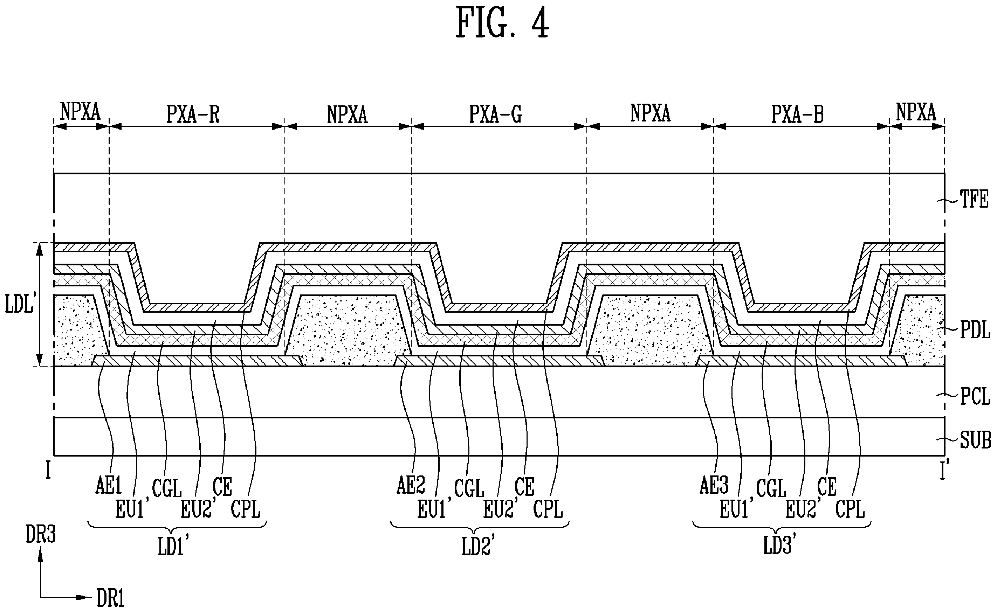

In one or more embodiments, the red emission area PXA-R may be an area where white light generated from a first light-emitting element LD1' (refer to FIG. 4) passes through a first color filter that transmits red light and blocks other colors of light, and thus red light is emitted. The green emission area PXA-G may be an area where white light generated from a second light-emitting element LD2' (refer to FIG. 4) passes through a second color filter that transmits green light and blocks other colors of light, and thus green light is emitted. The blue emission area PXA-B may be an area where white light generated from a third light-emitting element LD3' (refer to FIG. 4) passes through a third color filter that transmits blue light and blocks other colors of light, and thus blue light is emitted.

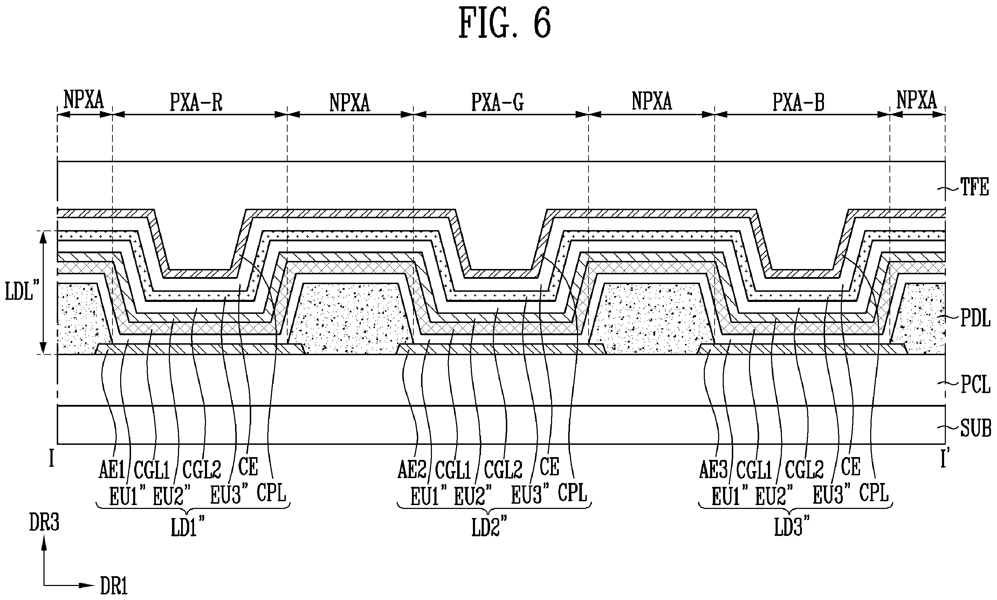

In one or more embodiments, the red emission area PXA-R may be an area where white light generated from a first light-emitting element LD1" (refer to FIG. 6) passes through a first color filter, and thus red light is emitted. The green emission area PXA-G may be an area where white light generated from a second light-emitting element LD2" (refer to FIG. 6) passes through a second color filter, and thus green light is emitted. The blue emission area PXA-B may be an area where white light generated from a third light-emitting element LD3" (refer to FIG. 6) passes through a third color filter, and thus blue light is emitted.

The red emission areas PXA-R, the green emission areas PXA-G, and the blue emission areas PXA-B may be arranged in a stripe shape. For example, the red emission areas PXA-R, the green emission areas PXA-G, and the blue emission areas PXA-B may be arranged along a second direction DR2, respectively. In some embodiments, the red emission area PXA-R, the green emission area PXA-G, and the blue emission area PXA-B may be arranged sequentially along a first direction DR1. However, embodiments are not necessarily limited thereto. For example, the red emission areas PXA-R, the green emission areas PXA-G, and the blue emission areas PXA-B may be arranged in a PENTILE^{®} shape, form or structure (e.g., an RGBG matrix, an RGBG structure, or an RGBG matrix structure), or a DIAMOND PIXEL^{™} shape, form or structure (e.g., a display (e.g., an OLED display) containing red, blue, and green (RGB) light emitting regions arranged in the shape of diamonds). PENTILE^{®} and DIAMOND PIXEL^{™} are trademarks owned by Samsung Display Co., Ltd. However, the disclosure is not limited thereto.

In FIG. 1, areas of the red emission area PXA-R, the green emission area PXA-G, and the blue emission area PXA-B are shown as being similar to each other, but embodiments are not necessarily limited thereto. The areas of the red emission area PXA-R, the green emission area PXA-G, and the blue emission area PXA-B may be different from each other according to a wavelength of emitted light. For example, the area of the red emission area PXA-R may be less than the area of the green emission area PXA-G, and the area of the green emission area PXA-G may be less than the area of the blue emission area PXA-B.

FIG. 2 is a cross-sectional view taken along line I-I' of FIG. 1 according to one or more embodiments.

Referring to FIG. 2, a substrate SUB may include a silicon wafer substrate formed through a semiconductor process. The substrate SUB may include a semiconductor material suitable for forming circuit elements. For example, the semiconductor material may include silicon, germanium, and/or silicon-germanium. The substrate SUB may be provided from a bulk wafer, an epitaxial layer, a silicon on insulator (SOI) layer, a semiconductor on insulator (SeOI) layer, and/or the like. However, embodiments are not necessarily limited thereto. For example, the substrate SUB may include a glass substrate, a polyimide (PI) substrate, and/or the like.

A pixel circuit layer PCL is arranged on the substrate SUB. The pixel circuit layer PCL may include insulating layers and conductive patterns arranged between the insulating layers. The conductive patterns of the pixel circuit layer PCL may function as at least a portion of circuit elements, lines, and/or the like. The circuit elements may include pixel circuits corresponding to each of the first to third light-emitting elements LD1 to LD3. The pixel circuits may include transistors and one or more capacitors. Each transistor may include a semiconductor portion including a source area, a drain area, and a channel area, and a gate electrode overlapping the semiconductor portion. Each capacitor may include electrodes spaced and/or apart (e.g., spaced apart or separated) from each other. The lines may include signal lines, for example, a gate line, an emission control line, a data line, and/or the like.

A light-emitting element layer LDL is arranged on the pixel circuit layer PCL.

First to third anodes AE1 to AE3 may be arranged on the pixel circuit layer PCL. The first anode AE1 may be provided in (or overlapped with) the red emission area PXA-R, the second anode AE2 may be provided in (or overlapped with) the green emission area PXA-G, and the third anode AE3 may be provided in (or overlapped with) the blue emission area PXA-B. The first to third anodes AE1 to AE3 may include a transparent conductive material such as indium tin oxide, indium zinc oxide, zinc oxide, indium gallium zinc oxide, and/or indium tin zinc oxide. However, embodiments are not necessarily limited thereto. For example, the first to third anodes AE1 to AE3 may include titanium nitride.

A pixel-defining layer PDL may be arranged on portions of the first to third anodes AE1 to AE3. The pixel-defining layer PDL may be arranged on the pixel circuit layer PCL to partially cover the first to third anodes AE1 to AE3. The pixel-defining layer PDL may include a plurality of inorganic insulating layers. The plurality of inorganic insulating layers may include an inorganic insulating material such as silicon oxide and/or silicon nitride. For example, the pixel-defining layer PDL may include first to third inorganic insulating layers sequentially stacked, and the first to third inorganic insulating layers may include silicon nitride, silicon oxide, and silicon nitride, respectively. However, embodiments are not necessarily limited thereto. For example, the pixel-defining layer PDL may include a plurality of organic insulating layers, and the plurality of organic insulating layers may include an organic insulating material such as polyimide, polyamide, acrylic resin, benzocyclobutene, and/or phenol resin.

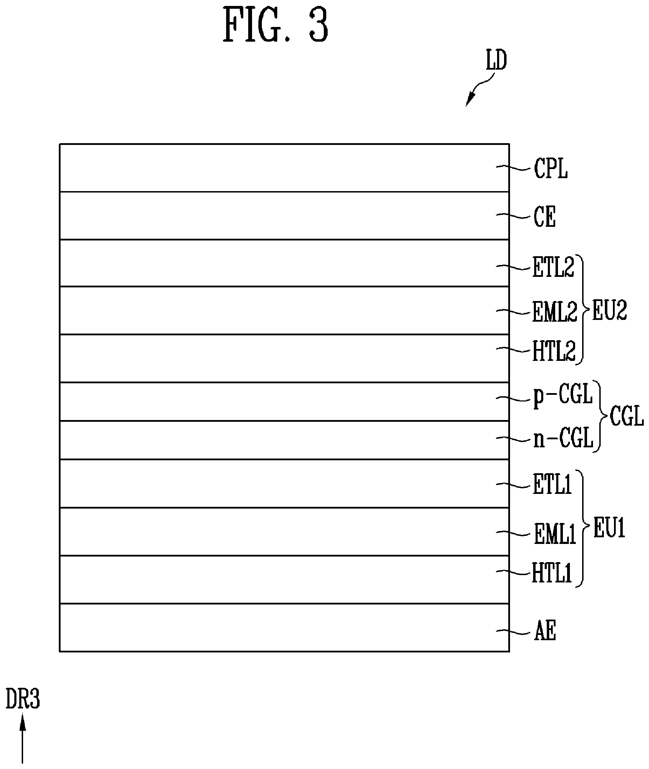

A hole transport layer HTL may be arranged on the first to third anodes AE1 to AE3 and the pixel-defining layer PDL. The hole transport layer HTL may be provided entirely over the red emission area PXA-R, the green emission area PXA-G, the blue emission area PXA-B, and the non-emission area NPXA. The hole transport layer HTL may have a single-layer structure including a hole transport material. The hole transport layer HTL may have substantially the same configuration as a first hole transport layer HTL1 (refer to FIG. 3). In embodiments, a hole injection layer may be arranged under the hole transport layer HTL.

A first red light-emitting layer EML-R1, the first green light-emitting layer EML-G1, and the first blue light-emitting layer EML-B1 may be arranged on the hole transport layer HTL. The first red light-emitting layer EML-R1, the first green light-emitting layer EML-G1, and the first blue light-emitting layer EML-B1 may be provided in (or overlapped with) the red emission area PXA-R, the green emission area PXA-G, and the blue emission area PXA-B, respectively. The first red light-emitting layer EML-R1 may include an organic light-emitting material, an inorganic light-emitting material, an organic/inorganic light-emitting material, a quantum dot, and/or the like generating red light. The first green light-emitting layer EML-G1 may include an organic light-emitting material, an inorganic light-emitting material, an organic/inorganic light-emitting material, a quantum dot, and/or the like generating green light. The first blue light-emitting layer EML-B1 may include an organic light-emitting material, an inorganic light-emitting material, an organic/inorganic light-emitting material, a quantum dot, and/or the like generating blue light.

A charge generation layer CGL may be arranged on the first red light-emitting layer EML-R1, the first green light-emitting layer EML-G1, the first blue light-emitting layer EML-B1, and the hole transport layer HTL. The charge generation layer CGL may be provided entirely over the red emission area PXA-R, the green emission area PXA-G, the blue emission area PXA-B, and the non-emission area NPXA. The charge generation layer CGL may include an n-type charge generation layer n-CGL (refer to FIG. 3) and a p-type charge generation layer p-CGL (refer to FIG. 3). In embodiments, a first electron transport layer ETL1 (refer to FIG. 3) may be arranged under the charge generation layer CGL.

A second red light-emitting layer EML-R2, a second green light-emitting layer EML-G2, and a second blue light-emitting layer EML-B2 may be arranged on the charge generation layer CGL. The second red light-emitting layer EML-R2, the second green light-emitting layer EML-G2, and the second blue light-emitting layer EML-B2 may be provided in (or overlapped with) the red emission area PXA-R, the green emission area PXA-G, and the blue emission area PXA-B, respectively. The second red light-emitting layer EML-R2 may be substantially the same as the first red light-emitting layer EML-R1, the second green light-emitting layer EML-G2 may be substantially the same as the first green light-emitting layer EML-G1, and the second blue light-emitting layer EML-B2 may be substantially the same as the first blue light-emitting layer EML-B1, but embodiments are not necessarily limited thereto.

An electron transport layer ETL may be arranged on the second red light-emitting layer EML-R2, the second green light-emitting layer EML-G2, the second blue light-emitting layer EML-B2, and the charge generation layer CGL. The electron transport layer ETL may be provided entirely over the red emission area PXA-R, the green emission area PXA-G, the blue emission area PXA-B, and the non-emission area NPXA. The electron transport layer ETL may have a single-layer structure including an electron transport material. The electron transport layer ETL may have substantially the same configuration as a second hole transport layer HTL2 (refer to FIG. 3).

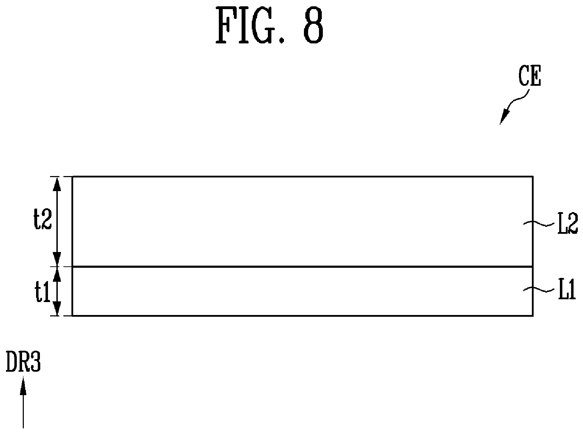

A cathode CE may be arranged on the electron transport layer ETL. The cathode CE may face the first to third anodes AE1 to AE3. The cathode CE may be provided entirely over the red emission area PXA-R, the green emission area PXA-G, the blue emission area PXA-B, and the non-emission area NPXA. In embodiments, an electron injection layer may be arranged under the cathode CE. One or more embodiments of a structure, material, and/or the like of the cathode CE is described elsewhere herein with reference to FIG. 8.

A capping layer CPL may be arranged on the cathode CE. The capping layer CPL may be provided entirely over the red emission area PXA-R, the green emission area PXA-G, the blue emission area PXA-B, and the non-emission area NPXA. The capping layer CPL may block an impurity such as moisture and/or air input from an outside. The capping layer CPL may be an inorganic insulating layer including an inorganic insulating material such as silicon nitride, aluminium nitride, titanium nitride, silicon oxide, aluminium oxide, titanium oxide, silicon oxycarbide, and/or silicon oxynitride. The capping layer CPL may have a single-layer or multi-layer structure including the herein-described material.

The first anode AE1, the hole transport layer HTL, the first red light-emitting layer EML-R1, the charge generation layer CGL, the second red light-emitting layer EML-R2, the electron transport layer ETL, the cathode CE, and the capping layer CPL provided in (or overlapped with) the red emission area PXA-R may configure the first light-emitting element LD1. The second anode AE2, the hole transport layer HTL, the first green light-emitting layer EML-G1, the charge generation layer CGL, the second green light-emitting layer EML-G2, the electron transport layer ETL, the cathode CE, and the capping layer CPL provided in (or overlapped with) the green emission area PXA-G may configure the second light-emitting element LD2. The third anode AE3, the hole transport layer HTL, the first blue light-emitting layer EML-B1, the charge generation layer CGL, the second blue light-emitting layer EML-B2, the electron transport layer ETL, the cathode CE, and the capping layer CPL overlapping the blue emission area PXA-B may configure the third light-emitting element LD3. The first light-emitting element LD1 may emit red light, the second light-emitting element LD2 may emit green light, and the third light-emitting element LD3 may emit blue light.

The encapsulation layer TFE may be arranged on the capping layer CPL. The encapsulation layer TFE may prevent or reduce penetration of an impurity, moisture, and/or the like. The encapsulation layer TFE may have a structure in which one or more inorganic layers and one or more organic layers are alternately stacked. However, embodiments are not necessarily limited thereto. For example, the encapsulation layer TFE may have a triple-layer structure in which an inorganic layer, an organic layer, and an inorganic layer are stacked.

FIG. 3 is a cross-sectional view of a light-emitting element according to one or more embodiments. The light-emitting element LD of FIG. 3 may be one of the first to third light-emitting elements LD1 to LD3 of FIG. 2.

Referring to FIG. 3, the light-emitting element LD may have a tandem structure including a first light-emitting unit EU1 and a second light-emitting unit EU2. For example, the light-emitting element LD may have a two stack tandem structure. The light-emitting element LD may emit light of a mono color. For example, the light-emitting element LD may emit one of red light, green light, and blue light.

The first light-emitting unit EU1 is arranged on an anode AE. The anode AE may be one of the first to third anodes AE1 to AE3 of FIG. 2. The first light-emitting unit EU1 may include the first hole transport layer HTL1, a first light-emitting layer EML1, and the first electron transport layer ETL1 sequentially stacked in the third direction DR3. The first light-emitting layer EML1 may be one of the first red light-emitting layer EML-R1, the first green light-emitting layer EML-G1, and the first blue light-emitting layer EML-B1 of FIG. 2.

The second light-emitting unit EU2 is arranged on the first light-emitting unit EU1. The second light-emitting unit EU2 may include the second hole transport layer HTL2, a second light-emitting layer EML2, and a second electron transport layer ETL2 sequentially stacked in the third direction DR3. The second light-emitting layer EML2 may emit light of the same color as the first light-emitting layer EML1. The second light-emitting layer EML2 may be one of the second red light-emitting layer EML-R2, the second green light-emitting layer EML-G2, and the second blue light-emitting layer EML-B2 of FIG. 2.

The charge generation layer CGL may be arranged between the first light-emitting unit EU1 and the second light-emitting unit EU2. The charge generation layer CGL may include an n-type charge generation layer n-CGL and a p-type charge generation layer p-CGL sequentially stacked in the third direction DR3.

The n-type charge generation layer n-CGL may provide an electron to the first light-emitting unit EU1. Holes injected from the anode AE and electrons injected from the n-type charge generation layer n-CGL may be transported into the first light-emitting layer EML1 of the first light-emitting unit EU1 to form excitons, and light may be generated when the excitons transit (e.g., transition) from an excited state to a ground state.

The p-type charge generation layer p-CGL may provide holes to the second light-emitting unit EU2. Holes injected from the p-type charge generation layer p-CGL and electrons injected from the cathode CE are transported into the second light-emitting layer EML2 of the second light-emitting unit EU2 to form excitons, and light may be generated when the excitons transition from an excited state to a ground state.

The cathode CE is arranged on the second light-emitting unit EU2. The capping layer CPL may be arranged on the cathode CE.

FIG. 4 is a cross-sectional view taken along line I-I' of FIG. 1 according to one or more embodiments. In FIG. 4, a description of a content overlapping that of FIG. 2 is briefly given or not included.

Referring to FIG. 4, a light-emitting element layer LDL' is arranged on the pixel circuit layer PCL.

A first light-emitting unit EU1' may be arranged on the first to third anodes AE1 to AE3 and the pixel-defining layer PDL. The first light-emitting unit EU1' may be provided entirely over the red emission area PXA-R, the green emission area PXA-G, the blue emission area PXA-B, and the non-emission area NPXA.

The charge generation layer CGL may be arranged on the first light-emitting unit EU1'.

A second light-emitting unit EU2' may be arranged on the charge generation layer CGL. The second light-emitting unit EU2' may be provided entirely over the red emission area PXA-R, the green emission area PXA-G, the blue emission area PXA-B, and the non-emission area NPXA.

The cathode CE is arranged on the second light-emitting unit EU2'.

The first anode AE1, the first light-emitting unit EU1', the charge generation layer CGL, the second light-emitting unit EU2', the cathode CE, and the capping layer CPL provided in (or overlapped with) the red emission area PXA-R may configure the first light-emitting element LD1'. The second anode AE2, the first light-emitting unit EU1', the charge generation layer CGL, the second light-emitting unit EU2', the cathode CE, and the capping layer CPL provided in (or overlapped with) the green emission area PXA-G may configure the second light-emitting element LD2'. The third anode AE3, the first light-emitting unit EU1', the charge generation layer CGL, the second light-emitting unit EU2', the cathode CE, and the capping layer CPL provided in (or overlapped with) the blue emission area PXA-R may configure the third light-emitting element LD3'. The first to third light-emitting elements LD1' to LD3' may emit white light.

A color filter layer may be arranged on the encapsulation layer TFE. The color filter layer may include a first color filter corresponding to the red emission area PXA-R (or the first light-emitting element LD1'), a second color filter corresponding to the green emission area PXA-G (or the second light-emitting element LD2'), and a third color filter corresponding to the blue emission area PXA-B (or the third light-emitting element LD3'). The first color filter may transmit red light and block other colors of light. The second color filter may transmit green light and block other colors of light. The third color filter may transmit blue light and block other colors of light. Accordingly, the white light emitted from the first to third light-emitting elements LD1' to LD3' may pass through the first to third color filters and may be emitted as red light, green light, and blue light, respectively.

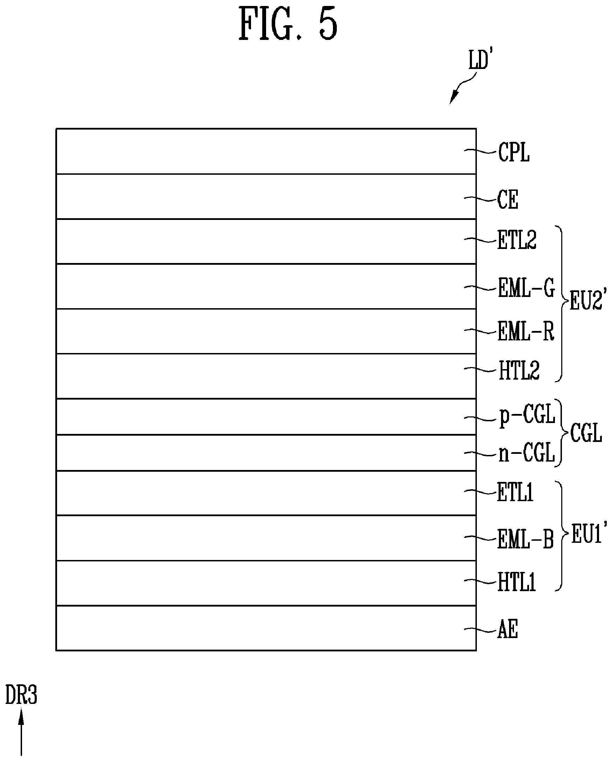

FIG. 5 is a cross-sectional view of a light-emitting element according to one or more embodiments. The light-emitting element LD' of FIG. 5 may be one of the first to third light-emitting elements LD1' to LD3' of FIG. 4.

Referring to FIG. 5, the light-emitting element LD' may have a tandem structure including a first light-emitting unit EU1' and a second light-emitting unit EU2'. For example, the light-emitting element LD' may have a two stack tandem structure. The light-emitting element LD' may emit light of mixed colors. For example, the light-emitting element LD' may emit white light mixed with red, green, and blue.

The first light-emitting unit EU1' is arranged on the anode AE. The anode AE may be one of the first to third anodes AE1 to AE3 of FIG. 4. The first light-emitting unit EU1' may include the first hole transport layer HTL1, the blue light-emitting layer EML-B, and the first electron transport layer ETL1 sequentially stacked in the third direction DR3. Accordingly, the first light-emitting unit EU1' may emit blue light.

The second light-emitting unit EU2' may be arranged on the first light-emitting unit EU1'. The second light-emitting unit EU2' may include the second hole transport layer HTL2, the red light-emitting layer EML-R, the green light-emitting layer EML-G, and the second electron transport layer ETL2 sequentially stacked in the third direction DR3. Accordingly, the second light-emitting unit EU2' may emit light of the mixed color of red and green.

The charge generation layer CGL is arranged between the first light-emitting unit EU1' and the second light-emitting unit EU2'. The charge generation layer CGL may include an n-type charge generation layer n-CGL and a p-type charge generation layer p-CGL sequentially stacked in the third direction DR3.

The n-type charge generation layer n-CGL may provide an electron to the first light-emitting unit EU1'. Holes injected from the anode AE and electrons injected from the n-type charge generation layer n-CGL may be transported into the blue light-emitting layer EML-B of the first light-emitting unit EU1' to form excitons, and light may be generated when the excitons transit (e.g., transition) from an excited state to a ground state.

The p-type charge generation layer p-CGL may provide a hole to the second light-emitting unit EU2'. Holes injected from the p-type charge generation layer p-CGL and electrons injected from the cathode CE may be transported into the red light-emitting layer EML-R and the green light-emitting layer EML-G of the second emitting unit EU2' to form excitons, and light may be generated when the excitons transit (e.g., transition) from an excited state to a ground state.

The cathode CE is arranged on the second emitting unit EU2'. The capping layer CPL may be arranged on the cathode CE.

FIG. 6 is a cross-sectional view taken along line I-I' of FIG. 1 according to one or more embodiments. In FIG. 6, a description of a content overlapping that of FIG. 2 is brief given or not included.

Referring to FIG. 6, a light-emitting element layer LDL" may be arranged on the pixel circuit layer PCL.

A first light-emitting unit EU1" may be arranged on the first to third anodes AE1 to AE3 and the pixel-defining layer PDL. The first light-emitting unit EU1" may be provided entirely over the red emission area PXA-R, the green emission area PXA-G, the blue emission area PXA-B, and the non-emission area NPXA.

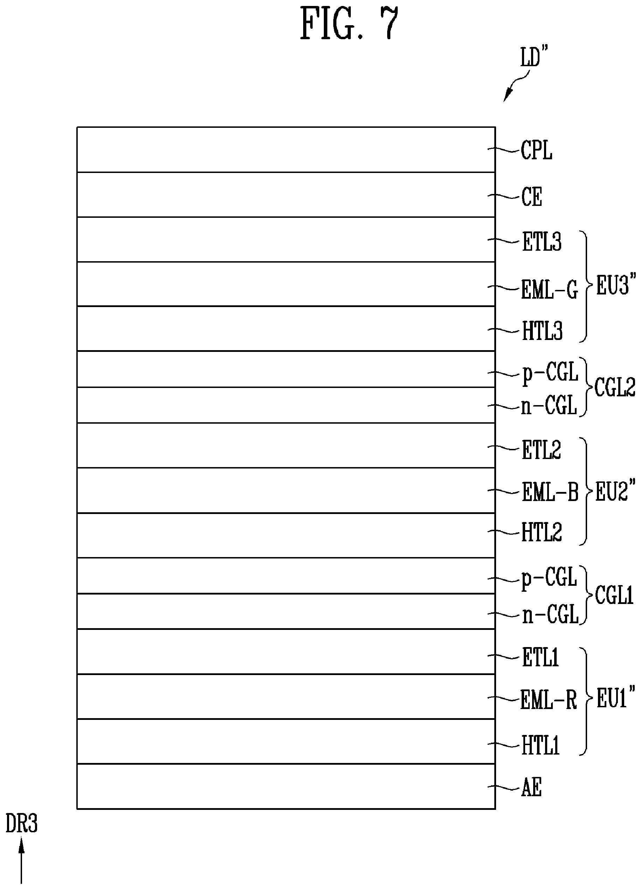

A first charge generation layer CGL1 is arranged on the first light-emitting unit EU1". The first charge generation layer CGL1 may be provided entirely over the red emission area PXA-R, the green emission area PXA-G, the blue emission area PXA-B, and the non-emission area NPXA. The first charge generation layer CGL1 may include an n-type charge generation layer n-CGL (refer to FIG. 7) and a p-type charge generation layer p-CGL (refer to FIG. 7).

A second light-emitting unit EU2" is arranged on the first charge generation layer CGL1. The second light-emitting unit EU2" may be provided entirely over the red emission area PXA-R, the green emission area PXA-G, the blue emission area PXA-B, and the non-emission area NPXA.

A second charge generation layer CGL2 may be arranged on the second light-emitting unit EU2". The second charge generation layer CGL2 may be provided entirely over the red emission area PXA-R, the green emission area PXA-G, the blue emission area PXA-B, and the non-emission area NPXA. The second charge generation layer CGL2 may include an n-type charge generation layer n-CGL (refer to FIG. 7) and a p-type charge generation layer p-CGL (refer to FIG. 7).

A third light-emitting unit EU3" may be arranged on the second charge generation layer CGL2. The third light-emitting unit EU3" may be provided entirely over the red emission area PXA-R, the green emission area PXA-G, the blue emission area PXA-B, and the non-emission area NPXA.

The cathode CE may be arranged on the third light-emitting unit EU3".

The first anode AE1, the first light-emitting unit EU1", the first charge generation layer CGL1, the second light-emitting unit EU2", the second charge generation layer CGL2, the third light-emitting unit EU3", the cathode CE, and the capping layer CPL provided in (or overlapped with) the red emission area PXA-R may configure the first light-emitting element LD1". The second anode AE2, the first light-emitting unit EU1", the first charge generation layer CGL1, the second light-emitting unit EU2", the second charge generation layer CGL2, the third light-emitting unit EU3", the cathode CE, and the capping layer CPL provided in (or overlapped with) the green emission area PXA-G may configure the second light-emitting element LD2". The third anode AE3, the first light-emitting unit EU1", the first charge generation layer CGL1, the second light-emitting unit EU2", the second charge generation layer CGL2, the third light-emitting unit EU3", the cathode CE, and the capping layer CPL provided in (or overlapped with) the blue emission area PXA-B may configure the third light-emitting element LD3". The first to third light-emitting elements LD1' to LD3' may emit white light.

The color filter layer may be arranged on the encapsulation layer TFE. The color filter layer may include a first color filter corresponding to the red emission area PXA-R (or the first light-emitting element LD1"), a second color filter corresponding to the green emission area PXA-G (or the second light-emitting element LD2"), and a third color filter corresponding to the blue emission area PXA-B (or the third light-emitting element LD3"). The first color filter may transmit red light and block other colors of light. The second color filter may transmit green light and block other colors of light. The third color filter may transmit blue light and block other colors of light. Accordingly, white light emitted from the first to third light-emitting elements LD1" to LD3" may pass through the first to third color filters, and may be emitted as red light, green light, and blue light, respectively.

FIG. 7 is a cross-sectional view of a light-emitting element according to one or more embodiments. A light-emitting element LD" of FIG. 7 may be one of the first to third light-emitting elements LD1" to LD3" of FIG. 6.

Referring to FIG. 7, the light-emitting element LD" may have a tandem structure including a first light-emitting unit EU1", a second light-emitting unit EU2", and a third light-emitting unit EU3". For example, the light-emitting element LD" may have a three stack tandem structure. The light-emitting element LD" may emit light of mixed colors. For example, the light-emitting element LD" may emit white light mixed with red, green, and blue.

The first light-emitting unit EU1" is arranged on the anode AE. The anode AE may be one of the first to third anodes AE1 to AE3 of FIG. 6. The first light-emitting unit EU1" may include the first hole transport layer HTL1, the red light-emitting layer EML-R, and the first electron transport layer ETL1 sequentially stacked in the third direction DR3. Accordingly, the first light-emitting unit EU1" may emit red light.

The second light-emitting unit EU2" may be arranged on the first light-emitting unit EU1". The second light-emitting unit EU2" may include the second hole transport layer HTL2, the blue light-emitting layer EML-B, and the second electron transport layer ETL2 sequentially stacked in the third direction DR3. Accordingly, the second light-emitting unit EU2" may emit blue light.

The third light-emitting unit EU3" may be arranged on the second light-emitting unit EU2". The third light-emitting unit EU3" may include a third hole transport layer HTL3, the green light-emitting layer EML-G, and a third electron transport layer ETL3 sequentially stacked in the third direction DR3. Accordingly, the third light-emitting unit EU3" may emit green light.

The first charge generation layer CGL1 is arranged between the first light-emitting unit EU1" and the second light-emitting unit EU2". The first charge generation layer CGL1 may include an n-type charge generation layer n-CGL and a p-type charge generation layer p-CGL sequentially stacked in the third direction DR3.

The second charge generation layer CGL2 may be arranged between the second light-emitting unit EU2" and the third light-emitting unit EU3". The second charge generation layer CGL2 may include an n-type charge generation layer n-CGL and a p-type charge generation layer p-CGL sequentially stacked in the third direction DR3.

The n-type charge generation layer n-CGL of the first charge generation layer CGL1 may provide an electron to the first light-emitting unit EU1". Holes injected from the anode AE and electrons injected from the n-type charge generation layer n-CGL of the first charge generation layer CGL1 may be transported into the red light-emitting layer EML-R of the first light-emitting unit EU1" to form excitons, and light may be generated when the excitons transit (e.g., transition) from an excited state to a ground state.

The p-type charge generation layer p-CGL of the first charge generation layer CGL1 may provide a hole to the second light-emitting unit EU2". The n-type charge generation layer n-CGL of the second charge generation layer CGL2 may provide an electron to the second light-emitting unit EU2". Holes injected from the p-type charge generation layer p-CGL of the first charge generation layer CGL1 and electrons injected from the n-type charge generation layer n-CGL of the second charge generation layer CGL2 may be transported into the blue light-emitting layer EML-B of the second light-emitting unit EU2" to form excitons, and light may be generated when the excitons transit (e.g., transition) from an excited state to a ground state.

The p-type charge generation layer p-CGL of the second charge generation layer CGL2 may provide a hole to the third light-emitting unit EU3". Holes injected from the p-type charge generation layer p-CGL of the second charge generation layer CGL2 and electrons injected from the cathode CE may be transported into the green light-emitting layer EML-G of the third emitting unit EU3" to form excitons, and light may be generated when the excitons transit (e.g., transition) from an excited state to a ground state.

The cathode CE may be arranged on the third emitting unit EU3". The capping layer CPL may be arranged on the cathode CE.

FIG. 8 is a cross-sectional view of a cathode according to one or more embodiments. The cathode CE of FIG. 8 may be applied to each of the light-emitting element LD of FIG. 3, the light-emitting element LD' of FIG. 5, and the light-emitting element LD" of FIG. 7.

Referring to FIG. 8, the cathode CE may have a double-layer structure including a first layer L1 and a second layer L2 sequentially stacked in the third direction DR3.

The first layer L1 includes a compound including a metal and a doping material (e.g., a doping material portion). For example, the metal may include silver (Ag), gold (Au), aluminium (Al), and/or chromium (Cr), but embodiments are not necessarily limited thereto. The doping material (e.g., doping material portion) is lithium (Li) (e.g., a lithium portion). For example, lithium (Li) may be doped to silver (Ag) and/or the like, by co-depositing lithium (Li) while depositing silver (Ag) and/or the like through thermal evaporation. An amount (e.g., a content) of lithium (Li) (e.g., lithium portion) may be 5 to 50 wt% based on a weight of the entire compound. A thickness t1 of the first layer L1 may be 5 nanometers (nm) to 20 nm. By doping lithium (Li), which has a relatively small extinction coefficient and work function, into silver (Ag), a light transmittance and an electron injection characteristic (or conductivity) of the cathode CE may be increased while securing a suitable or sufficient thickness of the cathode CE. Accordingly, light emission efficiency of the display device DD (refer to FIG. 1) may be increased.

The second layer L2 includes a transparent oxide. For example, the second layer L2 may include indium tin oxide and/or indium zinc oxide. However, embodiments are not necessarily limited thereto. For example, the second layer L2 may include zinc oxide, indium gallium zinc oxide, indium tin zinc oxide, and/or the like. The transparent oxide may be deposited through damage free sputtering. A thickness t2 of the second layer L2 may be 20 to 100 nm.

A process difficulty of forming the cathode CE having a double-layer structure may be lower than that of a cathode having a triple-layer or more structure. For example, the triple-layer or more structure may refer to a sandwich structure such as metal layer/transparent oxide layer/metal layer, metal layer/transparent oxide layer/metal layer/transparent oxide layer, and/or the like. Because the transparent oxide layer is deposited through the damage free sputtering, the cathode is transported into a sputtering chamber after depositing a metal layer through thermal evaporation. For example, the process difficulty of forming the cathode having the triple-layer or more structure may be relatively high due to a logistics issue involving repeated transportation during a manufacturing process.

According to one or more embodiments of the present disclosure, the display device may be included in one or more electronic devices. For example, the electronic devices may be smartphones, high-resolution smartphones, mobile phones, smart pads, smart watches, tablet PCs, electric vehicles, vehicle navigation systems, televisions, computer monitors, laptop computers, mobile communication terminals, electronic notebooks, portable multimedia players (PMPs), ultra-mobile PC (UMPCs), computers, billboards, Internet of Things (IoT) devices, watch phones, head-mounted displays (HMDs), and a (e.g., any suitable) combination thereof.

Terms such as "substantially," "about," and "approximately" are used as relative terms and not as terms of degree, and are intended to account for the inherent deviations in measured or calculated values that would be recognized by those of ordinary skill in the art. They may be inclusive of the stated value and an acceptable range of deviation as determined by one of ordinary skill in the art, considering the limitations and error associated with measurement of that quantity. For example, "about" may refer to one or more standard deviations, or ± 30%, 20%, 10%, 5% of the stated value.

Numerical ranges disclosed herein include and are intended to disclose all subsumed sub-ranges of the same numerical precision. For example, a range of "1.0 to 10.0" includes all subranges having a minimum value equal to or greater than 1.0 and a maximum value equal to or less than 10.0, such as, for example, 2.4 to 7.6. Applicant therefore reserves the right to amend this specification, including the claims, to expressly recite any sub-range subsumed within the ranges expressly recited herein.

The display device, the electronic device, a device of manufacturing thereof, and/or any other relevant devices or components according to embodiments of the present disclosure described herein may be implemented utilizing any suitable hardware, firmware (e.g., an application-specific integrated circuit), software, or a combination of software, firmware, and hardware. For example, the one or more suitable components of the display device may be formed on one integrated circuit (IC) chip or on separate IC chips. Further, the one or more suitable components of the display and/or electronic device may be implemented on a flexible printed circuit film, a tape carrier package (TCP), a printed circuit board (PCB), or formed on one substrate. Further, the one or more suitable components of the display and/or electronic device may be a process or thread, running on one or more processors, in one or more computing devices, executing computer program instructions and interacting with other system components for performing the one or more suitable functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, and/or the like. Also, a person of skill in the art should recognize that the functionality of one or more suitable computing devices may be combined or integrated into a single computing device, or the functionality of a particular computing device may be distributed across one or more other computing devices without departing from the scope of the embodiments of the present disclosure.

Hereinafter, a light-emitting element according to one or more embodiments of the present disclosure will be described referring to example embodiments and comparative examples. Examples described in more detail are each one example embodiment for enhancing understanding, and the scope of the present disclosure is not limited thereto.

### EXAMPLES

### Comparative Example 1

A light-emitting element C1 of comparative example 1 is the light-emitting element LD" (refer to FIG. 7) having the three stack tandem structure, and includes the cathode CE (refer to FIG. 8) including the first layer L1 (refer to FIG. 8) including silver (Ag) and having the thickness t1 (refer to FIG. 8) of 50 angstroms and the second layer L2 (refer to FIG. 8) including indium tin oxide (hereinafter referred to as 'ITO') and having the thickness t2 (refer to FIG. 8) of 1000 angstroms.

### Comparative Example 2

A light-emitting element C2 of comparative example 2 is the same as the light-emitting element C1 of comparative example 1, except that the second layer L2 of the cathode CE includes indium zinc oxide (hereinafter referred to as 'IZO').

### Comparative Example 3

A light-emitting element C3 of comparative example 3 is the light-emitting element LD" having the three stack tandem structure, and includes the cathode CE having a sandwich structure of Ag (5 angstroms)/ITO (400 angstroms)/Ag (5 angstroms)/ITO (400 angstroms). The numbers in parentheses represent a thicknesses of each layer.

### Example Embodiment 1

A light-emitting element E1 of example embodiment 1 is the light-emitting element LD" having the three stack tandem structure, and includes the cathode CE including the first layer L1 including a compound in which lithium (Li) is doped to silver (Ag) and having the thickness t1 of 50 angstroms, and the second layer L2 including IZO and having the thickness t2 of 450 angstroms. The amount (e.g., content) of lithium (Li) is 10 wt% based on the total weight of the compound.

### Example Embodiment 2

A light-emitting element E2 of example embodiment 2 is the same as the light-emitting element E1 of example embodiment 1, except that the thickness t1 of the first layer L1 of the cathode CE is 100 angstroms.

### Example Embodiment 3

A light-emitting element E3 of example embodiment 3 is the same as the light-emitting element E1 of example embodiment 1, except that the amount (e.g., content) of lithium (Li) is 20 wt%.

### Example Embodiment 4

A light-emitting element E4 of example embodiment 4 is the same as the light-emitting element E3 of example embodiment 3, except that the thickness t1 of the first layer L1 of the cathode CE is 100 angstroms.

### Example Embodiment 5

A light-emitting element E5 of example embodiment 5 is the same the light-emitting element E1 of example embodiment 1, except that the amount (e.g., content) of lithium (Li) is 30 wt%.

### Example Embodiment 6

A light-emitting element E6 of example embodiment 6 is the same the light-emitting element E5 of example embodiment 5, except that the thickness t1 of the first layer L1 of the cathode CE is 100 angstroms.

### Example Embodiment 7

A light-emitting element E7 of example embodiment 7 is the same as the light-emitting element E1 of example embodiment 1, except that the amount (e.g., content) of lithium (Li) is 50 wt%.

### Example Embodiment 8

A light-emitting element E8 of example embodiment 8 is the same the light-emitting element E7 of example embodiment 7, except that the thickness t1 of the first layer L1 of the cathode CE is 100 angstroms.

### Evaluation Example

Table 1 illustrates a driving voltage, a red color coordinate CIEx, and a red light emission efficiency of the red light-emitting layer EML-R (refer to FIG. 7) of each of the light-emitting elements C1 to C3 of comparative examples 1 to 3 and the light-emitting elements E1 to E8 of example embodiments 1 to 8.

**Table 1**

| | EML-R (RED) | | |
|---|---|---|---|
| | Driving voltage (V) | CIEx | Light emission efficiency (cd/A) |
| C1 | 100% | 0.680 | 100% |
| C2 | 100% | 0.680 | 100% |
| C3 | 100% | 0.680 | 101% |
| E1 | 110% | 0.680 | 102% |
| E2 | 115% | 0.680 | 103% |
| E3 | 102% | 0.680 | 105% |
| E4 | 100% | 0.680 | 107% |
| E5 | 101% | 0.680 | 103% |
| E6 | 100% | 0.680 | 106% |
| E7 | 99% | 0.680 | 101% |
| E8 | 98% | 0.680 | 100% |

Referring to Table 1, it may be confirmed that the red color coordinate CIEx is the same for the light-emitting elements C1 to C3 of comparative examples 1 to 3 and for the light-emitting elements E1 to E8 of example embodiments 1 to 8. It may be confirmed that the driving voltage of the light-emitting elements E1, E2, E3, and E5 of example embodiments 1 to 3 and 5 is slightly greater (e.g., somewhat increases), and the red light emission efficiency of the light-emitting elements E1, E2, E3, and E5 of example embodiments 1 to 3 and 5 is greater (e.g., increases) compared to that of the light-emitting elements C1 to C3 of comparative examples 1 to 3. It may be confirmed that the red light emission efficiency of the light-emitting elements E4 and E6 of example embodiments 4 and 6 is greater (e.g., increases) compared to that of the light-emitting elements C1 to C3 of comparative examples 1 to 3 without increasing the driving voltage. It may be confirmed that the driving voltage of the light-emitting element E7 of example embodiment 7 is less (e.g., decreases), and the red light emission efficiency of the light-emitting element E7 of example embodiment 7 is greater (e.g., increases) compared to that of the light-emitting elements C1 and C2 of comparative examples 1 and 2. It may be confirmed that the red light emission efficiency of the light-emitting element E8 of example embodiment 8 is the same, but the driving voltage of the light-emitting element E8 of example embodiment 8 is less (e.g., decreases) compared to that of the light-emitting elements C1 and C2 of comparative examples 1 and 2.

Table 2 illustrates a driving voltage, a blue color coordinate, and blue light emission efficiency of the blue light-emitting layer EML-B (refer to FIG. 7) of each of the light-emitting elements C1 to C3 of comparative examples 1 to 3 and the light-emitting elements E1 to E8 of example embodiments 1 to 8.

**Table 2**

| | | EML-B (BLUE) | |
|---|---|---|---|
| | Driving voltage (V) | CIEy | Light emission efficiency (cd/A) |
| C1 | 100% | 0.041 | 100% |
| C2 | 100% | 0.041 | 100% |
| C3 | 100% | 0.041 | 105% |
| E1 | 105% | 0.041 | 106% |
| E2 | 105% | 0.041 | 108% |
| E3 | 100% | 0.041 | 113% |
| E4 | 100% | 0.041 | 115% |
| E5 | 100% | 0.041 | 110% |
| E6 | 100% | 0.041 | 109% |
| E7 | 97% | 0.041 | 103% |
| E8 | 96% | 0.041 | 105% |

Referring to Table 2, it may be confirmed that the blue color coordinate CIEy is the same as that of the light-emitting elements C1 to C3 of comparative examples 1 to 3 and the light-emitting elements E1 to E8 of example embodiments 1 to 8. It may be confirmed that the driving voltage of the light-emitting elements E1 and E2 of example embodiments 1 and 2 is slightly greater (e.g., somewhat increases), but the blue light emission efficiency of the light-emitting elements E1 and E2 of example embodiments 1 and 2 is greater (e.g., increases) compared to that of the light-emitting elements C1 to C3 of comparative examples 1 to 3. It may be confirmed that the blue light emission efficiency of the light-emitting elements E3 to E6 of example embodiments 3 to 6 is greater (e.g., increases) compared to that of the light-emitting elements C1 to C3 of comparative examples 1 to 3 without increasing the driving voltage. It may be confirmed that the driving voltage of the light-emitting elements E7 and E8 of example embodiments 7 and 8 is less (e.g., decreases), and the blue light emission efficiency of the light-emitting elements E7 and E8 of example embodiments 7 and 8 is greater (e.g., increases) compared to that of the light-emitting elements C1 and C2 of comparative examples 1 and 2.

Table 3 illustrates a driving voltage, a green color coordinate, and green light emission efficiency of the green light-emitting layer EML-G (refer to FIG. 7) of each of the light-emitting elements C1 to C3 of comparative examples 1 to 3 and the light-emitting elements E1 to E8 of example embodiments 1 to 8.

**Table 3**

| | EML-G (GREEN) | | |
|---|---|---|---|
| | Driving voltage (V) | CIEx | Light emission efficiency (cd/A) |
| C1 | 100% | 0.234 | 100% |
| C2 | 100% | 0.234 | 100% |
| C3 | 100% | 0.234 | 103% |
| E1 | 104% | 0.234 | 102% |
| E2 | 103% | 0.234 | 103% |
| E3 | 100% | 0.234 | 110% |
| E4 | 100% | 0.234 | 111% |
| E5 | 100% | 0.234 | 106% |
| E6 | 100% | 0.234 | 108% |
| E7 | 95% | 0.234 | 102% |
| E8 | 96% | 0.234 | 103% |

Referring to Table 3, it may be confirmed that the green color coordinate CIEx is the same as that of the light-emitting elements C1 to C3 of comparative examples 1 to 3 and the light-emitting elements E1 to E8 of example embodiments 1 to 8. It may be confirmed that the driving voltage of the light-emitting elements E1 and E2 of embodiments 1 and 2 is slightly greater (e.g., somewhat increases), but the green light emission efficiency of the light-emitting elements E1 and E2 of example embodiments 1 and 2 is greater (e.g., increases) compared to that of the light-emitting elements C1 and C2 of comparative examples 1 and 2. It may be confirmed that the green light emission efficiency of the light-emitting elements E3 to E6 of example embodiments 3 to 6 is slightly greater (e.g., increases) compared to that of the light-emitting elements C1 to C3 of comparative examples 1 to 3 without increasing the driving voltage. It may be confirmed that the driving voltage of the light-emitting elements E7 and E8 of example embodiments 7 and 8 is less (e.g., decreases), and the green light emission efficiency of the light-emitting elements E7 and E8 of example embodiments 7 and 8 is greater (e.g., increases) compared to that of the light-emitting elements C1 and C2 of comparative examples 1 and 2.

Table 4 illustrates white light emission efficiency of each of the light-emitting elements C1 to C3 of comparative examples 1 to 3 and the light-emitting elements E1 to E8 of example embodiments 1 to 8.

**Table 4**

| | WHITE |
|---|---|
| | Light emission efficiency (cd/A) |
| C1 | 100% |
| C2 | 100% |
| C3 | 103% |
| E1 | 102% |
| E2 | 103% |
| E3 | 110% |
| E4 | 111% |
| E5 | 106% |
| E6 | 108% |
| E7 | 102% |
| E8 | 103% |

Referring to Table 4, it may be confirmed that the white light emission efficiency of the light-emitting elements E1, E2, E7, and E8 of example embodiments 1, 2, 7, and 8 is greater (e.g., increases) compared to that of the light-emitting elements C1 and C2 of comparative examples 1 and 2. It may be confirmed that the white light emission efficiency of the light-emitting elements E3 to E6 of example embodiments 3 to 6 is slightly greater (e.g., increases) compared to that of the light-emitting elements C1 to C3 of comparative examples 1 to 3. In particular, it may be confirmed that the white light emission efficiency of the light-emitting element E4 of embodiment 4 is significantly greater (e.g., greatly increases) compared to that of the light-emitting elements C1 to C3 of comparative examples 1 to 3.

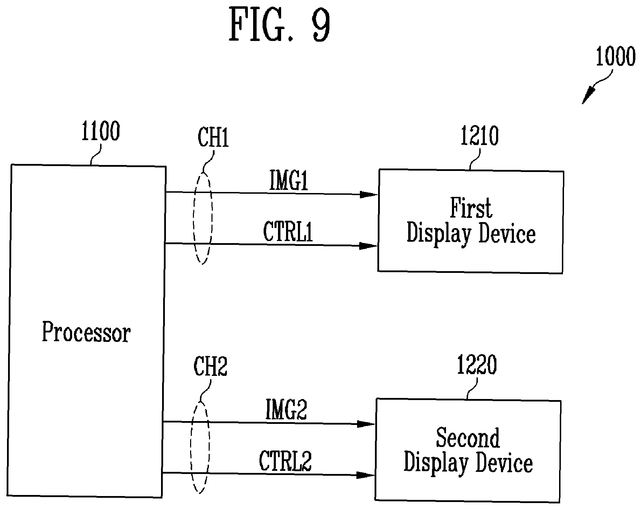

FIG. 9 is a block diagram of a display system according to one or more embodiments.

Referring to FIG. 9, the display system 1000 may include a processor 1100 and one or more display devices 1210 and 1220.

The processor 1100 may perform one or more suitable tasks and calculations. The processor 1100 may include an application processor, a graphic processor, a microprocessor, a central processing unit (CPU), and/or the like. The processor 1100 may be connected to other components of the display system 1000 through a bus system and may control the other components.

In FIG. 9, the display system 1000 includes the first and second display devices 1210 and 1220. The processor 1100 may be connected to the first display device 1210 through a first channel CH1 and may be connected to the second display device 1220 through a second channel CH2.

Through the first channel CH1, the processor 1100 may transmit first image data IMG1 and a first control signal CTRL1 to the first display device 1210. The first display device 1210 may display an image based on the first image data IMG1 and the first control signal CTRL1. The first display device 1210 may be configured similarly to the display device DD of FIG. 1.

Through the second channel CH2, the processor 1100 may transmit second image data IMG2 and a second control signal CTRL2 to the second display device 1220. The second display device 1220 may display an image based on the second image data IMG2 and the second control signal CTRL2. The second display device 1220 may be configured similarly to the display device DD of FIG. 1.

The display system 1000 may include a computing system providing an image display function, such as a portable computer, a mobile phone, a smart phone, a tablet personal computer (PC), a smart watch, a watch phone, a portable multimedia player (PMP), a navigation device, and an ultra mobile personal computer (UMPC). In some embodiments, the display system 1000 may include at least one of a head mounted display (HMD) device, a virtual reality (VR) device, a mixed reality (MR) device, and an augmented reality (AR) device.

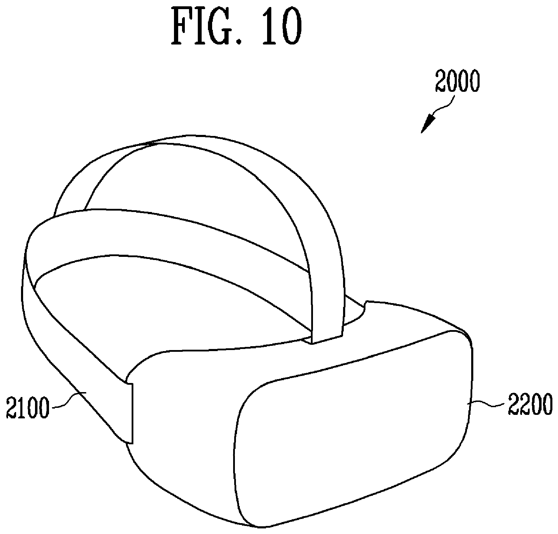

FIG. 10 is a perspective view illustrating an application example of the display system of FIG. 9 according to one or more embodiments.

Referring to FIG. 10, the display system 1000 of FIG. 9 may be applied to a head mounted display device 2000. The head mounted display device 2000 may be a wearable electronic device that may be worn on a user's head.

The head mounted display device 2000 may include a head mount band 2100 and a display device receiving case 2200. The head mount band 2100 may be connected to the display device receiving case 2200. The head mount band 2100 may include a horizontal band and/or a vertical band for fixing the head mounted display device 2000 to the user's head. The horizontal band may be configured to surround a side portion of the user's head, and the vertical band may be configured to surround an upper portion of the user's head. However, embodiments are not necessarily limited thereto. For example, the head mount band 2100 may be implemented in a glasses frame form, a helmet form, and/or the like.

The display device receiving case 2200 may receive the first and second display devices 1210 and 1220 of FIG. 9. The display device receiving case 2200 may further receive the processor 1100 of FIG. 9.

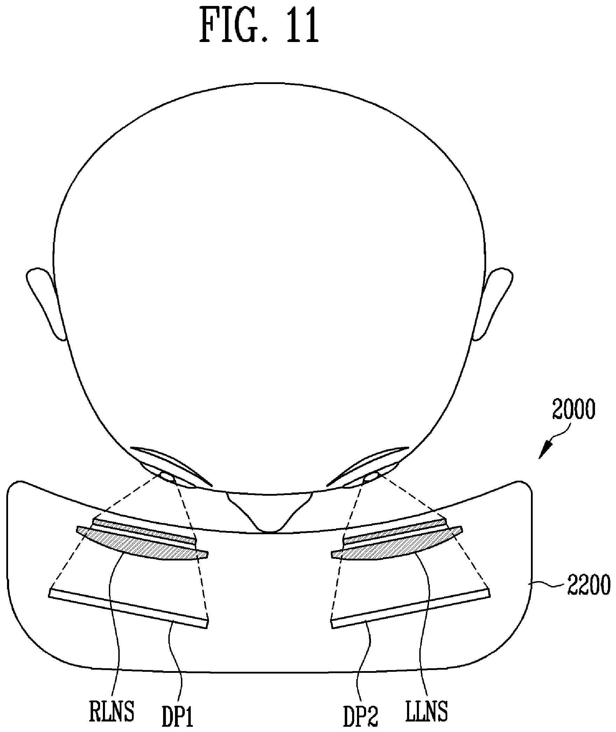

FIG. 11 is a cross-sectional view illustrating the head mounted display device of FIG. 10 worn by a user according to one or more embodiments.

Referring to FIG. 11, in the head mounted display device 2000, a first display panel DP1 of the first display device 1210 and a second display panel DP2 of the second display device 1220 are arranged. The head mounted display device 2000 may further include one or more lenses LLNS and RLNS.

Within the display device receiving case 2200, the right eye lens RLNS may be arranged between the first display panel DP1 and a user's right eye. Within the display device receiving case 2200, the left eye lens LLNS may be arranged between the second display panel DP2 and a user's left eye.

An image output from the first display panel DP1 may be displayed to the user's right eye through the right eye lens RLNS. The right eye lens RLNS may refract light from the first display panel DP1 to be directed toward the user's right eye. The right eye lens RLNS may perform an optical function for adjusting a viewing distance between the first display panel DP1 and the user's right eye.

According to some embodiments, by configuring the first layer of the cathode with a metal material doped with a doping material rather than a single metal material, light emission efficiency of the light-emitting element may be improved.

A person of ordinary skill in the art, in view of the present disclosure in its entirety, would appreciate that each suitable feature of the one or more suitable embodiments of the present disclosure may be combined or combined with each other, partially or entirely, and may be technically interlocked and operated in one or more suitable ways, and each embodiment may be implemented independently of each other or in conjunction with each other in any suitable manner unless otherwise stated or implied. However, the aspects and features of embodiments of the present disclosure are not limited to those described herein, and various other aspects and features as would be understood by those having ordinary skill in the art may be included in the present disclosure.

In the context of the present application and unless otherwise defined, the terms "use," "using," and "used" may be considered synonymous with the terms "utilize," "utilizing," and "utilized," respectively.

The foregoing is illustrative of some embodiments of the present disclosure, and is not to be construed as limiting thereof. Although some embodiments have been described, those skilled in the art will readily appreciate that various suitable modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

Embodiments are set out in the following clauses.
Clause 1. A light-emitting element, comprising:
   an anode;
   a cathode opposite to the anode;
   a first light-emitting unit on the anode;
   a first charge generation layer on the first light-emitting unit; and
   a second light-emitting unit between the first charge generation layer and the cathode,
   wherein the cathode comprises:
      a first layer comprising a compound comprising silver and a lithium portion; and
      a second layer on the first layer and comprising a transparent oxide.
Clause 2. The light-emitting element according to clause 1, wherein the lithium portion is a doping material.
Clause 3. The light-emitting element according to clause 2, wherein an amount of the lithium portion is about 5 wt% to about 50 wt% based on a total weight of the compound.
Clause 4. The light-emitting element according to any one of clauses 1 to 3, wherein a thickness of the first layer is about 5 nanometer (nm) to about 20 nm.
Clause 5. The light-emitting element according to any one of clauses 1 to 4, wherein a thickness of the second layer is about 20 nm to about 100 nm.
Clause 6. The light-emitting element according to any one of clauses 1 to 5, wherein the first light-emitting unit comprises a first hole transport layer; a first light-emitting layer on the first hole transport layer; and a first electron transport layer on the first light-emitting layer, and
   the second light-emitting unit comprises a second hole transport layer; a second light-emitting layer on the second hole transport layer; and a second electron transport layer on the second light-emitting layer,
   the first light-emitting layer and the second light-emitting layer each configured to emit light of a same color.
Clause 7. The light-emitting element according to any one of clauses 1 to 5, wherein the first light-emitting unit comprises a first hole transport layer; a blue light-emitting layer on the first hole transport layer; and a first electron transport layer on the blue light-emitting layer, and
   the second light-emitting unit comprises a second hole transport layer; a red light-emitting layer on the second hole transport layer; a green light-emitting layer on the red light-emitting layer; and a second electron transport layer on the green light-emitting layer.
Clause 8. The light-emitting element according to any one of clauses 1 to 5, further comprising:
   a second charge generation layer on the second light-emitting unit; and
   a third light-emitting unit between the second charge generation layer and the cathode.
Clause 9. The light-emitting element according to any one of clauses 1 to 8, wherein the first light-emitting unit comprises a first hole transport layer; a red light-emitting layer on the first hole transport layer; and a first electron transport layer on the red light-emitting layer,
   the second light-emitting unit comprises a second hole transport layer; a blue light-emitting layer on the second hole transport layer; and a second electron transport layer on the blue light-emitting layer, and
   the third light-emitting unit comprises a third hole transport layer; a green light-emitting layer on the third hole transport layer; and a third electron transport layer on the green light-emitting layer.
Clause 10. A display device, comprising:
   a pixel circuit layer on a substrate; and
   a light-emitting element layer on the pixel circuit layer,
   wherein the light-emitting element layer comprises:
      an anode;
      a cathode opposite to the anode;
      a first light-emitting unit on the anode;
      a first charge generation layer on the first light-emitting unit; and
      a second light-emitting unit between the first charge generation layer and the cathode, and
      the cathode comprises:
         a first layer comprising a compound comprising silver and a lithium portion; and
         a second layer on the first layer and comprising a transparent oxide.
Clause 11. The display device according to clause 10, wherein the lithium portion is a doping material.
Clause 12. The display device according to clause 11, wherein an amount of the lithium portion is about 5 wt% to about 50 wt% based on a total weight of the compound.
Clause 13. The display device according to any one of clauses 10 to 12, wherein a thickness of the first layer is about 5 nm to about 20 nm.
Clause 14. The display device according to any one of clauses 10 to 13, wherein a thickness of the second layer is about 20 nm to about 100 nm.
Clause 15. The display device according to any one of clauses 10 to 14, wherein the first light-emitting unit comprises a first hole transport layer; a first light-emitting layer on the first hole transport layer; and a first electron transport layer on the first light-emitting layer, and
   the second light-emitting unit comprises a second hole transport layer; a second light-emitting layer on the second hole transport layer; and a second electron transport layer on the second light-emitting layer,
   the first light-emitting layer and the second light-emitting layer each configured to emit light of a same color.
Clause 16. The display device according to any one of clauses 10 to 14, wherein the first light-emitting unit comprises a first hole transport layer; a blue light-emitting layer on the first hole transport layer; and a first electron transport layer on the blue light-emitting layer, and
   the second light-emitting unit comprises a second hole transport layer; a red light-emitting layer on the second hole transport layer; a green light-emitting layer on the red light-emitting layer; and a second electron transport layer on the green light-emitting layer.
Clause 17. The display device according to any one of clauses 10 to 14, further comprising:
   a second charge generation layer on the second light-emitting unit; and
   a third light-emitting unit between the second charge generation layer and the cathode.
Clause 18. The display device according to clause 17, wherein the first light-emitting unit comprises a first hole transport layer; a red light-emitting layer on the first hole transport layer; and a first electron transport layer on the red light-emitting layer,
   the second light-emitting unit comprises a second hole transport layer; a blue light-emitting layer on the second hole transport layer; and a second electron transport layer on the blue light-emitting layer, and
   the third light-emitting unit comprises a third hole transport layer; a green light-emitting layer on the third hole transport layer; and a third electron transport layer on the green light-emitting layer.
Clause 19. An electronic device comprising a display device comprising:
   a pixel circuit layer on a substrate; and
   a light-emitting element layer on the pixel circuit layer,
   wherein the light-emitting element layer comprises:
      an anode;
      a cathode opposite to the anode;
      a first light-emitting unit on the anode;
      a first charge generation layer on the first light-emitting unit; and
      a second light-emitting unit between the first charge generation layer and the cathode, and
      the cathode comprises:
         a first layer comprising a compound comprising silver and a lithium portion; and
         a second layer on the first layer and comprising a transparent oxide.
Clause 20. The electronic device of clause 19, wherein the electronic device is a smartphone, a high-resolution smartphone, a mobile phone, a smart pad, a smart watch, a tablet PC, an electric vehicle, a vehicle navigation system, a television, a computer monitor, a laptop computer, a mobile communication terminal, an electronic notebook, a portable multimedia player (PMP), an ultra-mobile PC (UMPC), a computer, a billboard, an Internet of Things (IoT) device, a watch phone, a head-mounted displays (HMD), and a combination thereof.

## Claims

1. A light-emitting element, comprising:
an anode;
a cathode opposite to the anode;
a first light-emitting unit on the anode;
a first charge generation layer on the first light-emitting unit; and
a second light-emitting unit between the first charge generation layer and the cathode,
wherein the cathode comprises:
a first layer comprising a compound comprising silver and a lithium portion; and
a second layer on the first layer and comprising a transparent oxide.

2. The light-emitting element according to claim 1, wherein the lithium portion is a doping material, optionally wherein an amount of the lithium portion is about 5 wt% to about 50 wt% based on a total weight of the compound.

3. The light-emitting element according to claim 1 or claim 2, wherein a thickness of the first layer is about 5 nm to about 20 nm.

4. The light-emitting element according to any one of claims 1 to 3, wherein a thickness of the second layer is about 20 nm to about 100 nm.

5. The light-emitting element according to any one of claims 1 to 4, wherein the first light-emitting unit comprises a first hole transport layer; a first light-emitting layer on the first hole transport layer; and a first electron transport layer on the first light-emitting layer, and
the second light-emitting unit comprises a second hole transport layer; a second light-emitting layer on the second hole transport layer; and a second electron transport layer on the second light-emitting layer,
the first light-emitting layer and the second light-emitting layer each configured to emit light of a same color.

6. The light-emitting element according to any one of claims 1 to 4, wherein the first light-emitting unit comprises a first hole transport layer; a blue light-emitting layer on the first hole transport layer; and a first electron transport layer on the blue light-emitting layer, and
the second light-emitting unit comprises a second hole transport layer; a red light-emitting layer on the second hole transport layer; a green light-emitting layer on the red light-emitting layer; and a second electron transport layer on the green light-emitting layer.

7. The light-emitting element according to any one of claims 1 to 4, further comprising:
a second charge generation layer on the second light-emitting unit; and
a third light-emitting unit between the second charge generation layer and the cathode, optionally wherein the first light-emitting unit comprises a first hole transport layer; a red light-emitting layer on the first hole transport layer; and a first electron transport layer on the red light-emitting layer,
the second light-emitting unit comprises a second hole transport layer; a blue light-emitting layer on the second hole transport layer; and a second electron transport layer on the blue light-emitting layer, and
the third light-emitting unit comprises a third hole transport layer; a green light-emitting layer on the third hole transport layer; and a third electron transport layer on the green light-emitting layer.

8. A display device, comprising:
a pixel circuit layer on a substrate; and
a light-emitting element layer on the pixel circuit layer,
wherein the light-emitting element layer comprises:
an anode;
a cathode opposite to the anode;
a first light-emitting unit on the anode;
a first charge generation layer on the first light-emitting unit; and
a second light-emitting unit between the first charge generation layer and the cathode, and
the cathode comprises:
a first layer comprising a compound comprising silver and a lithium portion; and
a second layer on the first layer and comprising a transparent oxide.

9. The display device according to claim 8, wherein the lithium portion is a doping material, optionally wherein an amount of the lithium portion is about 5 wt% to about 50 wt% based on a total weight of the compound.

10. The display device according to claim 8 or claim 9, wherein a thickness of the first layer is about 5 nm to about 20 nm.

11. The display device according to any one of claims 8 to 10, wherein a thickness of the second layer is about 20 nm to about 100 nm.

12. The display device according to any one of claims 8 to 11, wherein the first light-emitting unit comprises a first hole transport layer; a first light-emitting layer on the first hole transport layer; and a first electron transport layer on the first light-emitting layer, and
the second light-emitting unit comprises a second hole transport layer; a second light-emitting layer on the second hole transport layer; and a second electron transport layer on the second light-emitting layer,
the first light-emitting layer and the second light-emitting layer each configured to emit light of a same color.

13. The display device according to any one of claims 8 to 11, wherein the first light-emitting unit comprises a first hole transport layer; a blue light-emitting layer on the first hole transport layer; and a first electron transport layer on the blue light-emitting layer, and
the second light-emitting unit comprises a second hole transport layer; a red light-emitting layer on the second hole transport layer; a green light-emitting layer on the red light-emitting layer; and a second electron transport layer on the green light-emitting layer.

14. The display device according to any one of claims 8 to 11, further comprising:
a second charge generation layer on the second light-emitting unit; and
a third light-emitting unit between the second charge generation layer and the cathode, optionally wherein the first light-emitting unit comprises a first hole transport layer; a red light-emitting layer on the first hole transport layer; and a first electron transport layer on the red light-emitting layer,
the second light-emitting unit comprises a second hole transport layer; a blue light-emitting layer on the second hole transport layer; and a second electron transport layer on the blue light-emitting layer, and
the third light-emitting unit comprises a third hole transport layer; a green light-emitting layer on the third hole transport layer; and a third electron transport layer on the green light-emitting layer.

15. An electronic device comprising a display device comprising:
a pixel circuit layer on a substrate; and
a light-emitting element layer on the pixel circuit layer,
wherein the light-emitting element layer comprises:
an anode;
a cathode opposite to the anode;
a first light-emitting unit on the anode;
a first charge generation layer on the first light-emitting unit; and
a second light-emitting unit between the first charge generation layer and the cathode, and
the cathode comprises:
a first layer comprising a compound comprising silver and a lithium portion; and
a second layer on the first layer and comprising a transparent oxide, optionally wherein the electronic device is a smartphone, a high-resolution smartphone, a mobile phone, a smart pad, a smart watch, a tablet PC, an electric vehicle, a vehicle navigation system, a television, a computer monitor, a laptop computer, a mobile communication terminal, an electronic notebook, a portable multimedia player (PMP), an ultra-mobile PC (UMPC), a computer, a billboard, an Internet of Things (IoT) device, a watch phone, a head-mounted displays (HMD), and a combination thereof.
